(19) Europäisches Patentamt
European Patent Office
Office européen des brevets

(11) EP 0 861 922 A1

(12) EUROPÄISCHE PATENTANMELDUNG

(43) Veröffentlichungstag:
02.09.1998 Patentblatt 1998/36

(51) Int. Cl.⁶: C23C 16/26, C23C 16/30

(21) Anmeldenummer: 98102488.8

(22) Anmeldetag: 13.02.1998

(84) Benannte Vertragsstaaten:
AT BE CH DE DK ES FI FR GB GR IE IT LI LU MC NL PT SE
Benannte Erstreckungsstaaten:
AL LT LV MK RO SI

(30) Priorität: 24.02.1997 DE 19707232

(71) Anmelder:
Betonwerk C. Schmidt GmbH Abt. C. Hofmann - Entwicklung, Erprobung und Produktion von Textilmaschinenkomponenten
09116 Chemnitz (DE)

(72) Erfinder: Schmidt, Nico
09116 Chemnitz (DE)

(74) Vertreter: Schneider, Manfred
Patentanwaltsbüro Schneider
Annaberger Strasse 73
D-09111 Chemnitz (DE)

(54) Spinnring und Läufer für Ringspinnmaschinen

(57) Die Erfindung betrifft einen Spinnring (1) und einen Läufer (2) für Ringspinnmaschinen mit Gleitflächen zur Führung des Ringläufers beim Spinnprozeß mit einer harten Oberflächenschicht, die überwiegend aus angelagertem Kohlenstoff besteht.

Mit dem Ziel die Härte, die Reibwerte und die Korrosionsbeständigkeit zu verbessern, wird vorgeschlagen, daß die Funktionsschicht (F) der Oberflächenschicht eine plasma-modifizierte amorphe Kohlenwasserstoffschicht (Diamant like Carbon = DLC) ist, die nach dem PECVD-Verfahren (Plasma Enhanced Chemical Vapour Deposition) hergestellt wurde. In diese DLC-Schicht können auch Refraktärmetalle (W, Ta, Ti, Nb) oder nichtmetallische Stoffe (F, Si, $O_2$) eingefügt werden.

Fig. 1

EP 0 861 922 A1

# Beschreibung

Die Erfindung betrifft einen Spinnring und einen Läufer für Ringspinnmaschinen mit Gleitflächen Zur Führung des Ringläufers beim Spinnprozeß mit einer harten Oberflächenschicht, die überwiegend aus angelagertem Kohlenstoff besteht.

Spinnringe der obigen Art sind u. a. bekannt durch die DE 43 00 491.

In dieser Schrift wird vorgeschlagen, die Oberfläche des Spinnringes durch die Anlagerung von Kohlenstoffatomen zu beschichten. Unter Vakuum wurde das auf einem elektrischen Potential angebrachte Targetmaterial mittels Lichtbogen in ein Targetplasma überführt und in der Dampfphase unter Wirkung eines niedrigen, negativen elektrischen Potentials auf der Oberfläche des Spinnringes in Atombindung angelagert.

Empfohlen wurden Schichtdicken zwischen 3 und 5 µm.

Der so hergestellte Spinnring besitzt neben den Vorteilen der sehr großen Härte und des niedrigen Reibwiderstandes einige entscheidende Nachteile.

Unter den Bedingungen der mit extrem hoher Frequenz wechselnden Belastung bei oft wechselnder Temperatur (Arbeitstemperatur und Stillstand) der Spinnringe führten die unterschiedlichen Eigenschaften der Oberflächenschicht und des Grundkörpers vor allem im Grenzbereich beider Elemente zu hohen Spannungen. Das hatte zur Folge, daß die Oberflächenschicht aufriß. An den Rißstellen erhöhte sich die Belastung durch den Läufer. Nach und nach lösten sich Teile der Oberflächenschicht. Ein so beschädigter Spinnring war praktisch nicht mehr nutzbar. Der Spinnvorgang mußte unterbrochen und der Spinnring ausgetauscht werden.

Mit der DE 38 17 741 wurde vorgeschlagen, in die Oberfläche eines Spinnringes, der aus einem Stahl mit einem vorgegebenen Kohlenstoff- und Chromanteil Vanadiumcarbid bis zur Sättigungsgrenze zu diffundieren.

Damit wurden zwar die Verschleißerscheinungen geringer, eine Verbesserung der Reibwerte wurde jedoch nicht erreicht. Auch das nachträgliche Schleifen gemäß DE 38 36 670 brachte keine entscheidenden Veränderungen.

Bei den heute üblichen hohen Geschwindigkeiten der Läufer führten die hohen Reibwerte zu Temperaturen, bei denen Läufer und Ring nicht selten miteinander verschweißten. Die hohen Temperaturen am Läufer führten auch oft zu Fadenbrüchen.

Die Möglichkeiten der Schmierung des Ringes und/oder des Läufers waren seit jeher begrenzt, weil in diesem Bereich die Nähe des Garnes zu berücksichtigen war. Die Verwendung von Trockenschmiermitteln, wie Molubdändisulfit, war geboten.

Diese Trockenschmiermittel mußten auf der Oberfläche des Ringes gleichmäßig verteilt werden. Das kann man einigermaßen genau nur bei ausgebautem Spinnring vornehmen. Das Erneuern der Schmierschicht war deshalb mit der Demontage aller Spinnringe verbunden. Diesem Problem wich man dadurch aus, daß man das Trockenschmiermittel selektiv auf die Gleitflächen des Läufers aufbrachte (DE 40 15 276 A1).

Auch die Beschichtung der Spinnringe, z. B. mit Titanaluminiumnitrid (oder auch mit TiCN bzw. TiN), das mittels CVD- oder PVD-Verfahren aufgebracht wurde, (DE 42 19 197 A1) war unbefriedigend, weil die Reibwerte nach wie vor zu hoch waren.

Ohne Erfolg blieben bisher auch die Versuche der Beschichtung des Ringes mit einer polykristallinen Keramik gemäß DE 43 42 148. Es gelang bisher nicht, die Korngrenzen dieser Keramikkristalle im Bereich der Oberflächen ausreichend und zuverlässig abzurunden.

Die Aufgabe der Erfindung ist es, eine Beschichtungsart für den Spinnring zu finden, die neben einer großen Härte und Verschleißfestigkeit auch sehr niedrige Reibwerte und damit vertretbare Betriebstemperaturen am Spinnring bei hohen Geschwindigkeiten gewährleistet.

Die Oberfläche und ihre Verbindung mit dem Grundkörper soll auch unter den praktischen Bedingungen des Spinnvorganges bei hohen Temperaturen (bis 400 °C) mit schnellen Abkühlungen bei Unterbrechungen des Spinnvorganges stabil bleiben. Wünschenswert ist auch, daß eine evtl. abgearbeitete Oberflächenschicht problemlos erneuert werden kann.

Erfindungsgemäß wird diese Aufgabe durch die kennzeichnenden Merkmale der Ansprüche 1 bis 3 auf überraschend einfache und komplexe Weise gelöst.

Die modifizierten DLC-Schichten besitzen eine hohe abrassive Verschleißfestigkeit bei sehr niedrigem Reibwert. Die Reibwerte erreichen das Niveau der Trockenschmierung. Die Lebensdauer der Spinnringe wird deutlich erhöht. Die DLC-Schichten sind chemisch inert und können bis zu einer Temperatur von 400° eingesetzt werden.

Die Spinnringe sind durch die Struktur der Funktionsschicht und deren Elastizität hermetisch gegen das Eindringen von Feuchte geschützt. Sie sind damit besonders für den Einsatz in feuchtwarmer Umgebung geeignet.

Die DLC-Schichten sind bei Relativgeschwindigkeiten zwischen dem Spinnring und dem Läufer von bis zu 45 m/s geeignet, die Adhäsionsneigung und das Kaltschweißen zu vermeiden.

Die Lösungsform nach Anspruch 1 ist in besonderer Weise zu empfehlen, wenn bei einer hohen Druckbelastung eine hohe Elastizität und ein wirksamer Schutz gegen mechanische Beanspruchungen gefordert wird.

Die Gestaltung der Oberfläche nach Anspruch 2 wird dann besonders empfohlen, wenn die Eigenspannungen der Funktionsschicht reduziert werden sollen. Die Schichthaftung wird dann auch bei häufig wechselnder Temperatur und bei wechselnder mechanischer Belastung in einem hohen Maße gewährleistet.

Eine Beschichtung nach Anspruch 3 ermöglicht, bei Beibehaltung des Verschleißwiderstandes und der niedrigen Reibwerte, zusätzlich die Reduzierung der Verschmutzungsneigung des Ringes an der Oberfläche.

Mit dem Einfügen von Zwischenschichten, insbesondere solchen aus Refraktärmetallen (W, Ta, Ti, Nb) nach Anspruch 4, wird die Schichthaftung zuverlässig erhöht. Die Wahl der Schichtdicken nach den Ansprüchen 5 bis 7 ist jeweils optimal auf die Struktur der Funktionsschicht abgestimmt. Die Komplettbeschichtung nach Anspruch 8 vermeidet nicht nur die Zeitaufwendung zur selektiven Beschichtung der Oberfläche. Der komplette Spinnring wird auf diese Weise zuverlässig gegen jede Korrission geschützt. Das trifft auch dann zu, wenn der Grundkörper nicht aus rostfreiem Stahl gefertigt ist oder wenn ein bereits abgearbeiteter Ring als Grundkörper verwendet wird.

Mit der Verwendung eines aluminiumlegierten Grundkörpers nach Anspruch 9 werden die anstrebenswerten Eigenschaften der Funktionsschicht ebenfalls erreicht. Die Herstellung dieses Grundkörpers kann jedoch deutlich vereinfacht werden.

Mit der Ausgestaltung auch des Läufers mit einer DLC-Schicht mit einer in den Ansprüchen 1 bis 3 definierten Form kann man den Veschleiß insgesamt noch niedriger halten. Notwendig ist jedoch dann, daß man hinsichtlich der Festigkeit die notwendige Differenzierung berücksichtigt (Ansprüche 10 und 11).

Die Erfindung soll nachstehend an einem einfachen Ausführungsbeispiel näher erläutert werden. In den dazugehörigen Zeichnungen zeigen

Fig. 1 einen beliebig gestalteten Spinnring im Querschnitt mit der Darstellung der Position des Läufers, der Spule und des Fadens zur Darstellung der Belastungsart,

Fig. 2 einen schematischen Querschnitt durch einen Teil der Funktionsschicht, die nur aus DLC besteht,

Fig. 3 einen Querschnitt gemäß Fig. 2 mit mehreren DLC-Schichten und eingefügten Metallschichten und

Fig. 4 einen Querschnitt gemäß Fig. 2 mit mehreren DLC-Schichten und eingefügten nichtmetallischen Elementen.

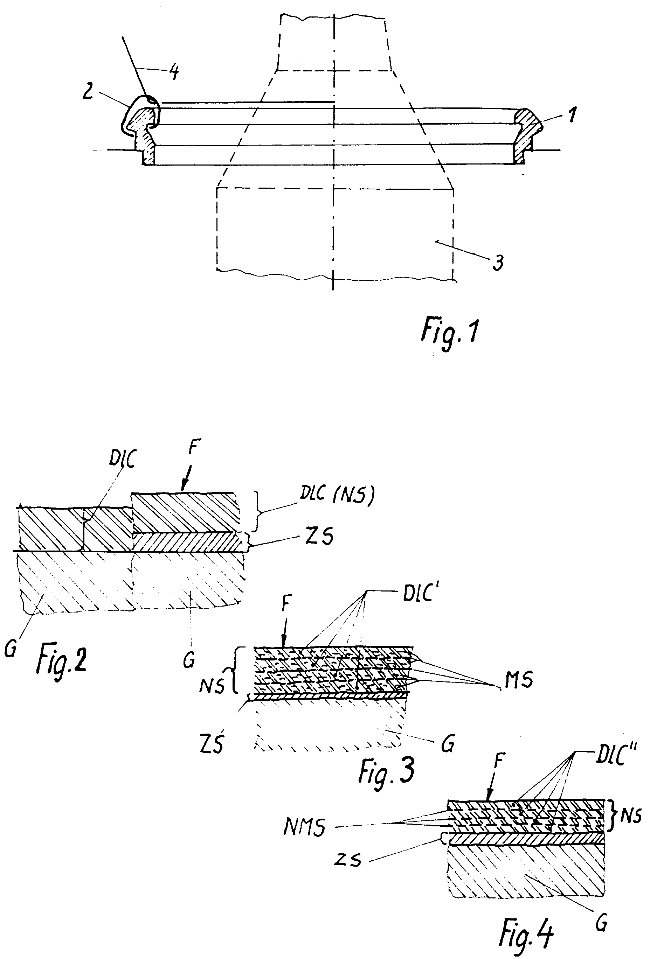

Zur Darstellung des Belastungsfalles am Spinnring sind in Fig. 1 die einzelnen zusammenwirkenden Elemente dargestellt. Die Spindel bzw. Spule 3 wird mit etwa 6.000 bis 10.000 Umdrehungen/Minute und mehr angetrieben.

Durch die Reibung des Läufers 2 auf dem oberen Abschnitt des Spinnringes 1 wird der Faden 4 zurückgehalten und im möglichen Maße auf die Spule 3 der Spindel aufgewickelt. Der Läufer 2 muß hier - belastet durch den Faden und die große Fliehkraft - am Oberteil des Spinnringes 1 gleitend geführt werden.

Die Geschwindigkeiten zwischen Läufer 2 und Spinnring 1 liegen im Durchschnitt bei 40 m/s. Es ist einzusehen, daß diese hohe Geschwindigkeit und die dabei auftretenden Fliehkräfte besonders hohe Ansprüche an die Gleitfläche stellen.

In den Fig. 2 bis 4 sind unterschiedliche Schichtformen insbesondere für die Oberfläche des Spinnringes 1, an der der Läufer 2 geführt wird, stark vergrößert dargestellt.

In Fig. 2 ist die DLC-Schicht auf den Grundkörper G im linken Abschnitt direkt aufgetragen. Im rechten Abschnitt ist eine Zwischenschicht ZS eingefügt. Mit ihr reduziert man den plötzlichen Übergang zwischen der weniger hohen Festigkeit des Grundkörpers G und der extrem hohen Festigkeit der DLC-Funktionsschicht.

Die DLC-Funktionsschicht ist eine plasmamodifizierte amorphe Kohlenwasserstoffschicht, die man üblicherweise als sog. DLC-Schicht (diamant like carbon) bezeichnet. Diese Schicht wird mit dem ebenfalls bekannten PECVD-Verfahren (Plasma Enhenced Chemical Vapour Deposition) erzeugt. Auf die Beschreibung dieses Verfahrens soll an dieser Stelle nicht weiter eingegangen werden.

Es ist möglich, über dieses Verfahren und über die damit erzeugte Oberflächenschicht in der DE 195 45 050 A1 nachzulesen.

Die nach diesem Verfahren hergestellte DLC-Schicht besitzt nach außen hin eine nahezu glatte Oberfläche, die einen vernetzten Charakter hat. Diese DLC-Schicht überzieht gleichmäßig die Oberfläche des Grundkörpers und verhindert neben der Schaffung guter Verschleiß- und Gleiteigenschaften auch das Eindringen von Feuchtigkeit bis zur Oberfläche des Grundkörpers (G).

Die genannten Schichten werden auch zum Zweck des Korrosionsschutzes eingesetzt.

Die in Fig. 2 dargestellte Schicht besitzt eine Schichtdicke der Nutzschicht NS zwischen 1,0 bis 10 µm und eine Härte > 2.000 HV. Sie hat eine überdurchschnittliche Elastizität. Das Verhältnis der elastischen zur plastischen Verformung liegt bei 3,3.

Auch ohne Zwischenschicht ZS erreicht man ein gutes Haftvermögen. Eine Zwischenschicht ZS, vorzugsweise aus Reaktärmetallen W, Ta, Ti oder Nb, kann dieses Haftvermögen noch verbessern. Die Reibwerte dieser DLC-Schicht liegen bei 0,1 bis 0,2 bei den hier üblichen Belastungen. Das Kaltschweißverhalten dieser DLC-Schicht ist radikal reduziert.

Die in Fig. 3 dargestellte Nutzschicht NS kann wahlweise mit oder ohne Zwischenschicht ZS aufgebracht werden. Bei der Zwischenschichtvariante werden diese unmittelbar vor dem Aufbringen der DLC-Schichten abgeschieden.

Nach der Fertigstellung jener dünnen (0,1 bis 1 µm) Refraktärmetall-Zwischenschicht werden gleichzeitig die DLC-Schichten und die Refraktärmetalle (durch Zerstäubung eines Refraktärmetalltargets) aufgebracht. Solche Refraktärmetalle sind Wolfram, Tantal, Titan oder Niob.

Der Prozeß des Auftragens derartiger Schichten MS während des eingangs definierten Verfahrens muß hier nicht im einzelnen beschrieben werden.

Es empfiehlt sich hier mit magnetfeldgestützter Gleichstromaufladung und DC-Magnetoren zu arbeiten.

Die Eigenschaften einer solchen Funktionsschicht ( F = DLC + MS ) liegen in der weiteren Reduktion der Eigenspannung der Schicht. Hier kan man Schichtdicken bis 15 μm arbeiten.

Die Haftung der Schicht wird verbessert. Der Metallanteil bestimmt auch im erheblichen Maße die Reibungs- und Verschleißeigenschaften dieser Schichten.

Unter Verwendung einer Zwischenschicht ZS aus diesen Refraktärmetallen kann die Schichthaftung bis über 40 N vergrößert werden. Zwischenschichten aus einer Cr- oder Ni-Matrix mit eingefügten Diamantpartikeln sind zu empfehlen.

Die dritte Grundvariante ist in Fig. 4 dargestellt. Hier fügt man anstelle der Metallschichten MS, mehr oder weniger gleichmäßig verteilt, nichtmetallische Elemente, wie Flour, Silizium oder Sauerstoff ein. Die Schichtdicken betragen hier max. 8 μm. Es werden Härtegrade bis 1.000 HV erreicht. Der besondere Vorteil dieser Schichten nach Fig. 4 besteht in der Reduzierung der Verschmutzungsneigung der Oberfläche.

Die Reibwerte werden bei allen Varianten gemäß Fig. 2, 3 und 4 in gleicher Weise gewährleistet. Unterschiedlich im praktisch nutzbaren Bereich ist lediglich die Härte der Schichten. Die notwendige Härte wird im einzelnen durch die Bedingungen beim Spinnprozeß bestimmt.

Das Prinzip des Auftragens dieser DLC-Schichten und die Bewerkstelligung der Haftung dieser Schichten auf den Grundkörper ist nicht abhängig von der Verwendung von Stahl oder Eisen oder bestimmter Legierungsbestandteile des Eisens.

Es ist auch möglich, diese DLC-Schichten auf dem wesentlich einfacher herstellbaren zerspanbaren Spinnring 1 aus einer Aluminiumverbindung anzuordnen.

Die Schichthaftung, die Verschleißwerte und der sehr günstige Reibwert werden auch hier problemlos erreicht.

Es kann jedoch notwendig werden, zusätzliche, unterschiedliche Zwischenschichten vorzusehen, mit denen eine schlagartige Festigkeitsänderung vermieden wird.

Es ist sinnvoll die Spinnringe 1 nicht nur im Bereich der Gleitflächen des Läufers 2 zu beschichten sondern den Gesamtkörper des Spinnringes 1 an sich.

Mit dieser Maßnahme erhöht man die Korrosionsbeständigkeit des Spinnringes insbesondere unter tropischen und subtropischen Bedingungen.

Es ist natürlich auch im Sinne der vorliegenden Erfindung den Läufer 2 mit mindestens einer DLC-Schicht zu versehen. Bei der Paarung von Läufer und Spinnring mit DLC Beschichtung ist natürlich zu beachten, daß nicht beide Teile der Paarung die gleiche Härte aufweisen. So kann man einem Spinnring 1 mit reiner DLC-Beschichtung einen Läufer 2 zuordnen, bei dem Metallschichten MS oder Nichtmetallschichten NMS eingefügt sind.

Genau so kann man einem Läufer 2 mit reiner DLC-Schicht auch Spinnringe 1 zuordnen, die entweder mit Metallschichten MS oder mit Nichtmetallen NMS angereichert sind.

Alle Zwischenkombinationen sind möglich, wenn man die Graduierung von mindestens einer Stufe beachtet.

## Bezugszeichenliste

| | |
|---|---|
| 1 | Spinnring |
| 2 | Läufer |
| 3 | Spule |
| F | Funktionsschicht |
| DLC, DLC', DLC'' | DLC-Schichten |
| MS | Metallschicht |
| NMS | Nichtmetallschicht |
| ZS | Zwischenschicht |
| G | Grundkörper |

## Patentansprüche

1. Spinnring für Ringspinnmaschinen mit Gleitflächen zur Führung des Ringläufers beim Spinnprozeß mit einer harten Oberflächenschicht, die überwiegend aus angelagertem Kohlenstoff besteht, **dadurch gekennzeichnet,**
   **daß** die Funktionsschicht (F) der Oberflächenschicht eine plasma-modifizierte amorphe Kohlenwasserstoffschicht (Diamant like Carbon = DLC) ist, die nach dem PECVD-Verfahren (Plasma Enhanced Chemical Vapour Deposition) hergestellt wurde.

2. Spinnring für Ringspinnmaschinen mit Gleitflächen zur Führung des Ringläufers beim Spinnprozeß mit einer harten Oberflachenschicht, die überwiegend aus angelagertem Kohlenstoff besteht, **dadurch gekennzeichnet,**
   **daß** die Funktionsschicht (F) der Oberflächenschicht eine metallhaltige Polymerstruktur hat, die aus plasma-modifizierten amphoren Kohlenwasserstoffschichten (DLC') besteht, in die Refraktärmetalle (z. B. W, Ta, Ti oder Nb) eingefügt sind.

3. Spinnring für Ringspinnmaschinen mit Gleitflächen zur Führung des Ringläufers beim Spinnprozeß mit einer harten Oberflächenschicht, die überwiegend aus angelagertem Kohlenstoff besteht, **dadurch gekennzeichnet,**
   **daß** die Funktionsschicht (F) der Oberflächenschicht eine Polymerstruktur aus DLC''-Schichten mit eingefügten nichtmetallischen Elementen (F, Si, $O_2$) hat.

4. Spinnring nach einem der Ansprüche 1 bis 3, **dadurch gekennzeichnet,**

**daß** zwischen dem Grundkörper (Substrat G) des Ringes und der Funktionsschicht (F) eine Zwischenschicht (ZS) aus Refraktärmetallen eingefügt ist.

5. Spinnring nach Anspruch 1, **dadurch gekennzeichnet,**
   **daß** die Schichtdicke der Funktionsschicht (F = DLC) 1,0 bis 10 µm beträgt.

6. Spinnring nach Anspruch 2, **dadurch gekennzeichnet,**
   **daß** die Schichtdicke der Funktionsschicht ( F = DLC' + MS ) 1,0 bis 15 µm beträgt.

7. Spinnring nach Anspruch 3, **dadurch gekennzeichnet,**
   **daß** die Schichtdicke der Funktionsschicht ( F = DLC + NMS ) 1,0 bis 8 µm beträgt.

8. Spinnring nach Anspruch 1 bis 7, **dadurch gekennzeichnet,**
   **daß** die gesamte Oberfläche des Spinnringes (1) eine Funktionsschicht (F) mit mindestens einer DLC-Schicht aufweist.

9. Spinnring nach einem der Ansprüche 1 bis 3, **dadurch gekennzeichnet,**
   **daß** der Grundkörper (G) des Spinnringes (1) aus einer Aluminiumlegierung besteht.

10. Läufer für einen Spinnring, **dadurch gekennzeichnet,**
   **daß** auch der Läufer mit mindestens einer DLC-Schicht nach einem der Ansprüche 1 bis 3 versehen ist.

11. Spinnring - Läufer - Paarung **dadurch gekennzeichnet,**
   **daß** beide Elemente (1,2) mit mindestens einer DLC-Schicht versehen sind und daß die Härte beider Elemente um mindestens eine Festigkeitsstufe von der des anderen Elementes abweicht.

Fig. 1

Fig. 2

Fig. 3

Fig. 4

Europäisches
Patentamt

**EUROPÄISCHER RECHERCHENBERICHT**

Nummer der Anmeldung

EP 98 10 2488

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | DATABASE WPI<br>Section Ch, Week 9310<br>Derwent Publications Ltd., London, GB;<br>Class F01, AN 93-080847<br>XP002067119<br>-& JP 05 025 718 A (SUMITOMO METAL IND LTD) | 1,5 | C23C16/26<br>C23C16/30 |
| Y | * Zusammenfassung * | 2-4,10,11 | |
| Y | DE 37 03 078 A (BARMAG BARMER MASCHF)<br>20.August 1987<br>* das ganze Dokument * | 2-4,10,11 | |
| Y | DE 32 46 361 A (PHILIPS PATENTVERWALTUNG)<br>8.September 1983<br>* Seite 8, Zeile 34 - Seite 9, Zeile 7;<br>Ansprüche 1-12; Beispiel 2 * | 2-4,10,11 | |
| A,D | DE 43 00 491 A (CARL HOFMANN RINGLAEUFER UND R) 14.Juli 1994<br>* Spalte 3, Zeile 29 - Zeile 44 * | 1-11 | RECHERCHIERTE SACHGEBIETE (Int.Cl.6) |
| A | DE 37 12 205 A (REPENNING DETLEV DIPL CHEM DR) 20.Oktober 1988<br>* Ansprüche 1-11 * | 1-11 | C23C<br>D01H |
| A | DE 44 20 262 A (ZEXEL CORP) 15.Dezember 1994<br>* Beispiel 1 * | 1-11 | |

-/--

Der vorliegende Recherchenbericht wurde für alle Patentansprüche erstellt

| Recherchenort | Abschlußdatum der Recherche | Prüfer |
|---|---|---|
| DEN HAAG | 5.Juni 1998 | Ekhult, H |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes
    Dokument

EPO FORM 1503 03.82 (P04C03)

Europäisches Patentamt

Nummer der Anmeldung

EP 98 10 2488

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A | ORAL B ET AL: "ADHESION AND STRUCTURAL CHANGES OF MULTI-LAYERED AND MULTI-DOPED A-C:H FILMS DURING ANNEALING" DIAMOND AND RELATED MATERIALS, Bd. 5, Nr. 9, Juli 1996, Seiten 932-937, XP000685029 * Seite 933, linke Spalte, Zeile 1 - Zeile 12 * | 4 | |
| A | US 4 677 817 A (KANAI HIROYUKI) 7.Juli 1987 * Spalte 1, Zeile 43 - Zeile 68 * | 10 | |
| A | PATENT ABSTRACTS OF JAPAN vol. 010, no. 161 (C-352), 10.Juni 1986 & JP 61 012931 A (HIROYUKI KANAI), 21.Januar 1986, * Zusammenfassung * | 9 | |
| A | US 5 077 990 A (PLATH ERNST-DIETER) 7.Januar 1992 * Spalte 1, Zeile 34 - Zeile 68 * | 11 | RECHERCHIERTE SACHGEBIETE (Int.Cl.6) |
| A | DIMIGEN H ET AL: "Applying low-friction wear-resistant thin solid films by physical vapour deposition" PHILIPS TECHNICAL REVIEW, 1983-1984, NETHERLANDS, Bd. 41, Nr. 6, ISSN 0031-7926, Seiten 186-197, XP002067116 * Abbildung 13 * | 11 | |

Der vorliegende Recherchenbericht wurde für alle Patentansprüche erstellt

| Recherchenort | Abschlußdatum der Recherche | Prüfer |
|---|---|---|
| DEN HAAG | 5.Juni 1998 | Ekhult, H |